# EUROPEAN PATENT APPLICATION

(11) **EP 4 814 157 A1**
(43) Date of publication of application: **30.09.2026**
(21) Application number: 25166103.9
(22) Date of filing: 25.03.2025
(51) Int. Cl.: C23C 14/50, H01L 21/687, H01L 21/67

(54) **DUAL-TILT LARGE-AREA COLLIMATED COATING DEVICE AND CARRIER MODULE**

(71) Applicant: AdNaNotek Corp., 242048 New Taipei City (TW)
(72) Inventor: YANG, KAI, TAIPEI CITY (TW)
(74) Representative: Durán-Corretjer, S.L.P.

(57) **Abstract**

A dual-tilt large-area collimated coating device (Z) and a carrier module (D). The dual-tilt large-area collimated coating device (Z) includes a base module (1), a rotating module (2) and a carrier module (D). The rotating module (2) is movably arranged on the base module (1). The carrier module (D) includes a module body (D1), a carrier assembly (D2), a first driving assembly (D3) and a second driving assembly (D4). The module body (D1) is connected to the rotating module (2), and has an accommodating space (D10), a first opening (D11), and a plurality of shielding elements (D12). The accommodating space (D10) is communicated with the first opening (D11). The shielding elements (D12) are configured to open or shield the first opening (D11). The carrier assembly (D2) is configured to hold an object (B). The first driving assembly (D3) is configured to drive the carrier assembly (D2) to perform a reciprocating displacement in a predetermined direction. The second driving assembly (D4) is configured to drive the carrier assembly (D2) to rotate around a first axis (AC2).

## Description

### FIELD OF THE INVENTION

The present invention relates to a coating device and a carrier module, and more particularly to a dual-tilt large-area collimated coating device and a carrier module capable of making the film thickness of the object more uniform during tilt coating.

### BACKGROUND OF THE INVENTION

In the manufacturing process of various products such as semiconductors, displays, and optical disks, a thin film may be formed on a workpiece such as a wafer or a glass substrate.

However, during the coating process of the workpiece, the current coating equipment cannot perform uniform coating on the workpiece when the workpiece is in a tilted state.

### SUMMARY OF THE INVENTION

In response to the above-referenced technical inadequacy, the present invention provides a dual-tilt large-area collimated coating device and a carrier module.

In order to solve the above-mentioned problems, one of the technical aspects adopted by the present invention is to provide a dual-tilt large-area collimated coating device, which includes a base module, a rotating module movably disposed on the base module, and a carrier module. The carrier module includes: a module body connected to the rotating module, the module body having an accommodating space, a first opening and a plurality of shielding elements, the accommodating space being in communication with the first opening, the plurality of shielding elements being movably disposed on the module body, and the plurality of shielding elements being configured to open or close the first opening; a carrier assembly located in the accommodating space, and the carrier assembly being configured to hold at least one object; at least one first driving assembly movably connected to the carrier assembly, and the at least one first driving assembly being configured to drive the carrier assembly to reciprocate in a first direction or a second direction; and a second driving assembly movably connected to the carrier assembly, and the second driving assembly being configured to drive the carrier assembly to rotate around a first axis.

In order to solve the above-mentioned problems, another one of the technical aspects adopted by the present invention is to provide a carrier module applied to a dual-tilt large-area collimated coating device, and the carrier module includes: a module body connected to the dual-tilt large-area collimated coating device, the module body having an accommodating space, a first opening and a plurality of shielding elements, the accommodating space being in communication with the first opening, the plurality of shielding elements being movably disposed on the module body, and the plurality of shielding elements being configured to open or close the first opening; a carrier assembly located in the accommodating space, and the carrier assembly being configured to hold at least one object; at least one first driving assembly movably connected to the carrier assembly, and the at least one first driving assembly being configured to drive the carrier assembly to reciprocate in a first direction; and a second driving assembly movably connected to the carrier assembly, and the second driving assembly being configured to drive the carrier assembly to rotate around a first axis.

One of the beneficial effects of the present invention is that the dual-tilt large-area collimated coating device and the carrier module provided by the present invention can make the film thickness coated on the object more uniform during the tilt coating through the above-mentioned technical solution.

These and other aspects of the present invention will become apparent from the following description of the embodiment taken in conjunction with the following drawings and their captions, although variations and modifications therein may be affected without departing from the scope of the invention that is defined by the attached claims.

### BRIEF DESCRIPTION OF THE DRAWINGS

The described embodiments may be better understood by reference to the following description and the accompanying drawings, in which:
FIG. 1 is a schematic perspective view of a dual-tilt large-area collimated coating device according to a first embodiment of the present invention;
FIG. 2 is another schematic perspective view of the dual-tilt large-area collimated coating device according to the first embodiment of the present invention;
FIG. 3 is a partial schematic exploded view of a rotating module according to the first embodiment of the present invention;
FIG. 4 is a partial schematic cross-sectional view of the dual-tilt large-area collimated coating device according to the first embodiment of the present invention;
FIG. 5 is a schematic top view of the dual-tilt large-area collimated coating device according to the first embodiment of the present invention;
FIG. 6 is a schematic perspective assembled view of a carrier module according to the first embodiment of the present invention;
FIG. 7 is a schematic perspective exploded view of the carrier module according to the first embodiment of the present invention;
FIG. 8 is a schematic view of the dual-tilt large-area collimated coating device in a first use state according to the first embodiment of the present invention;
FIG. 9 is a schematic view of the dual-tilt large-area collimated coating device in a second use state according to the first embodiment of the present invention;
FIG. 10 is a schematic structural diagram of a blocking module according to a second embodiment of the present invention; and
FIG. 11 is a functional block diagram of the dual-tilt large-area collimated coating device according to the second embodiment of the present invention.

### DETAILED DESCRIPTION OF THE EXEMPLARY EMBODIMENTS

The present invention is more particularly described in the following embodiments and examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

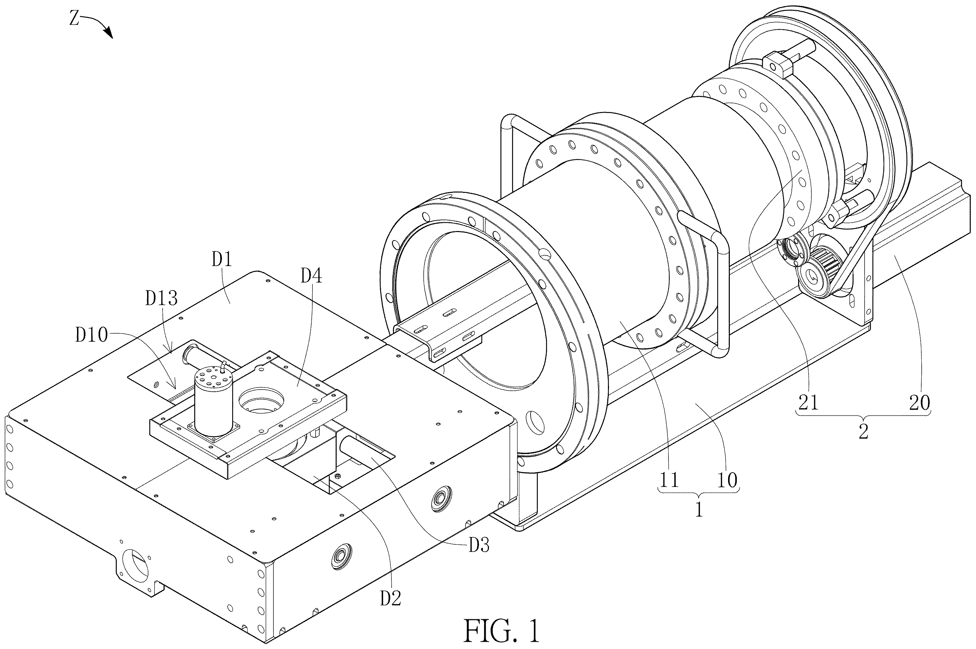

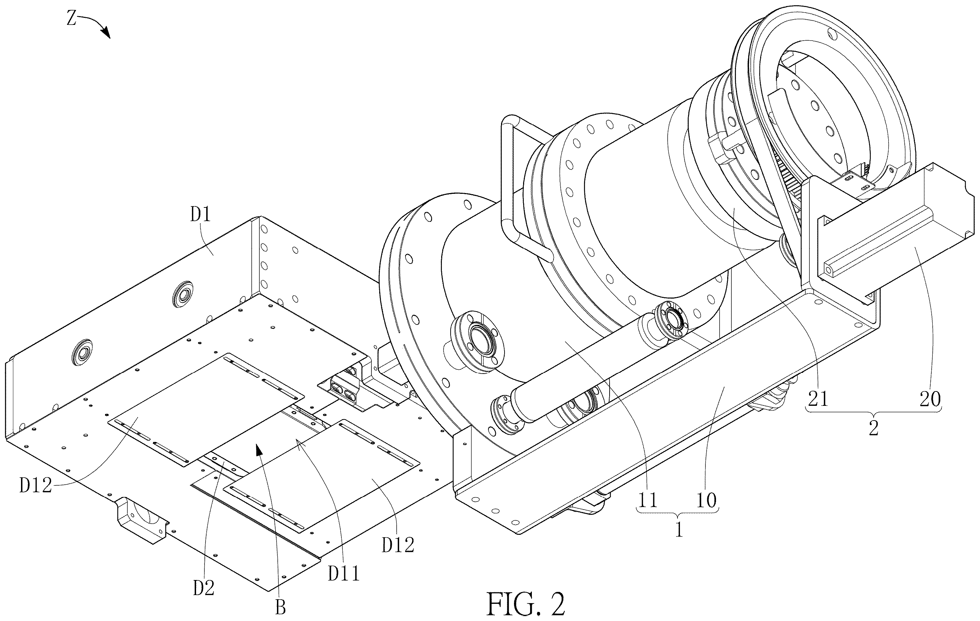

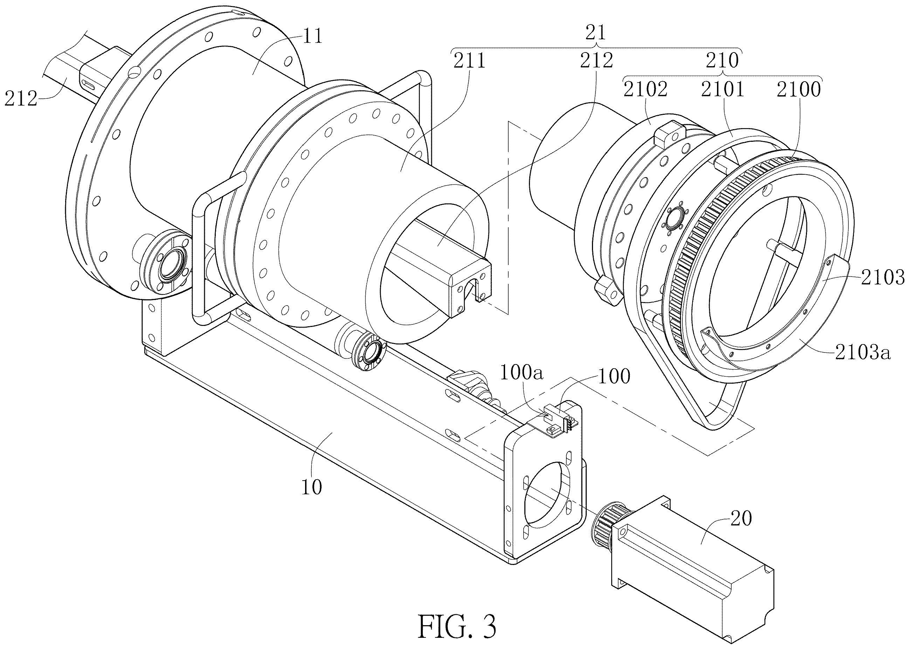

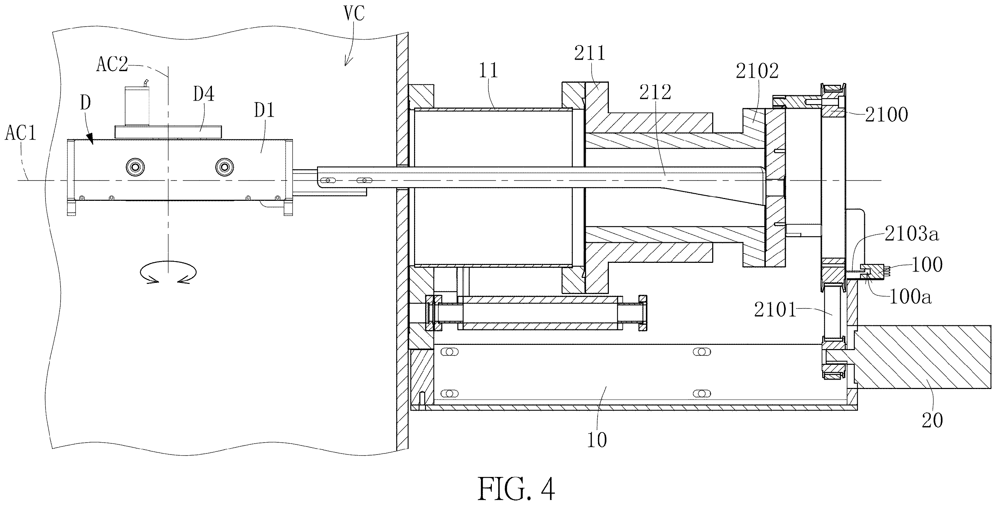

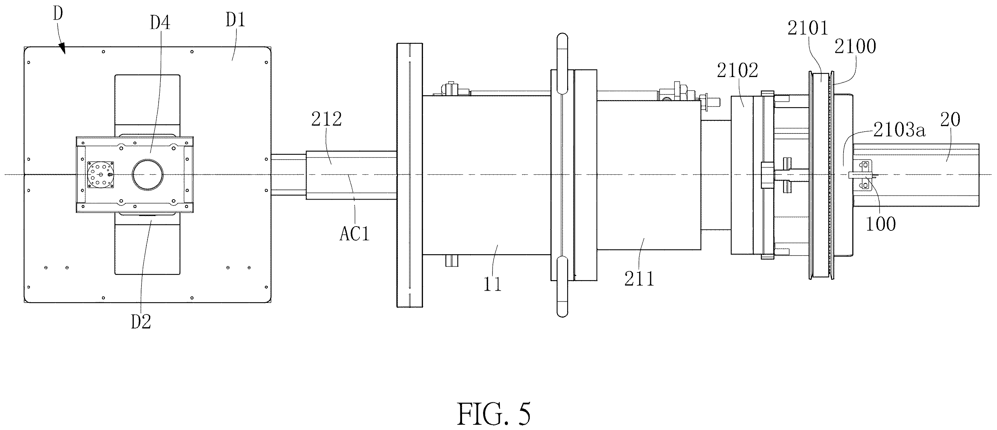

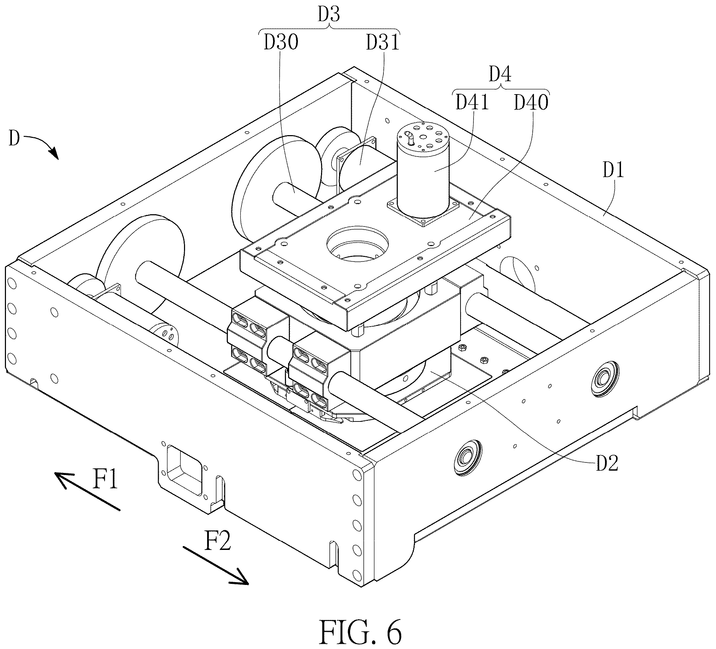

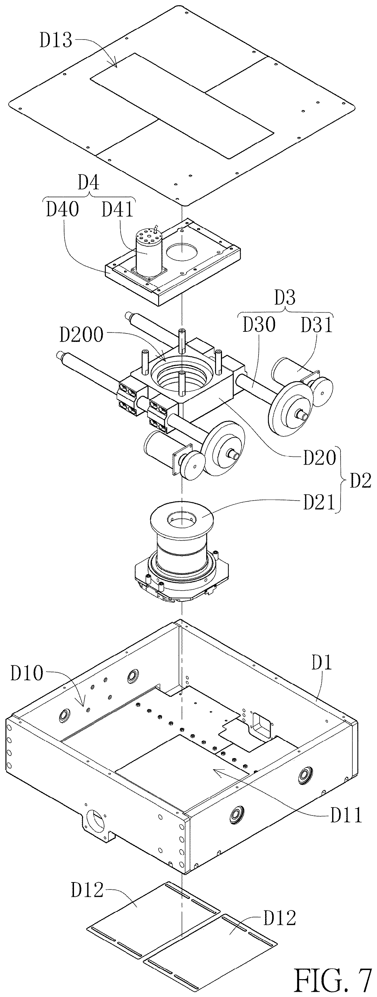

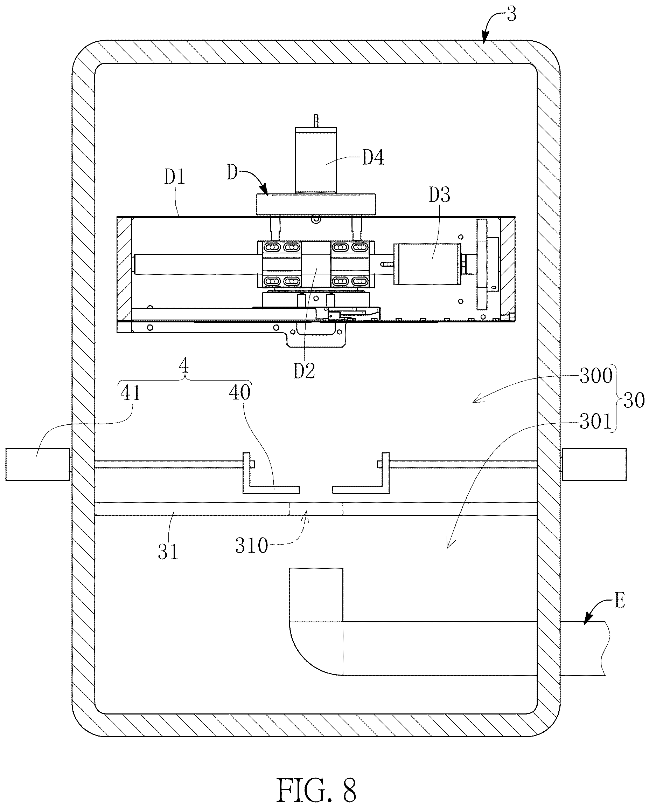

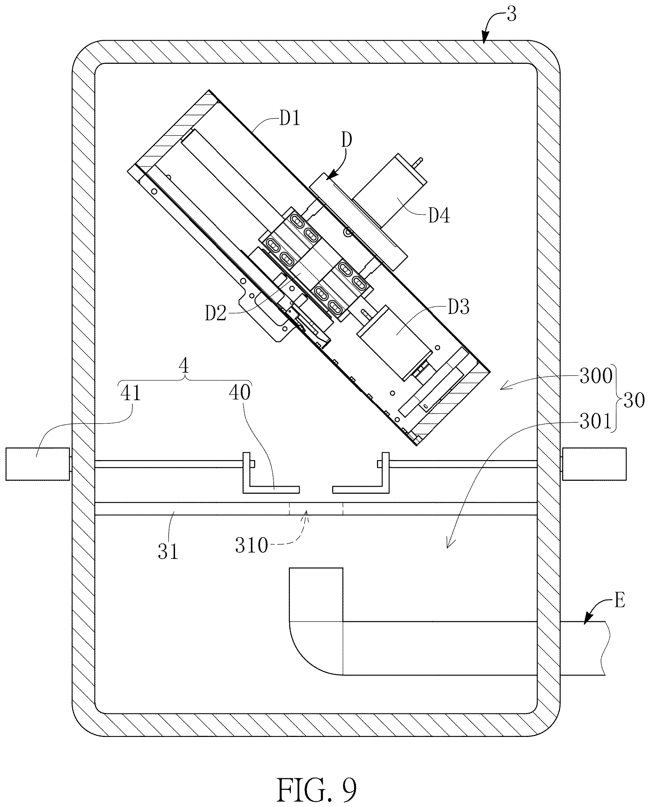

Referring to FIG. 1 to FIG. 9, in which FIG. 1 is a schematic perspective view of a dual-tilt large-area collimated coating device according to a first embodiment of the present invention, FIG. 2 is another schematic perspective view of the dual-tilt large-area collimated coating device according to the first embodiment of the present invention, FIG. 3 is a partial schematic exploded view of a rotating module according to the first embodiment of the present invention, FIG. 4 is a partial schematic cross-sectional view of the dual-tilt large-area collimated coating device according to the first embodiment of the present invention, FIG. 5 is a schematic top view of the dual-tilt large-area collimated coating device according to the first embodiment of the present invention, FIG. 6 is a schematic perspective assembled view of a carrier module according to the first embodiment of the present invention, FIG. 7 is a schematic perspective exploded view of the carrier module according to the first embodiment of the present invention, FIG. 8 is a schematic view of the dual-tilt large-area collimated coating device in a first use state according to the first embodiment of the present invention, and FIG. 9 is a schematic view of the dual-tilt large-area collimated coating device in a second use state according to the first embodiment of the present invention. As shown in the above figures, the first embodiment of the present invention provides a dual-tilt (double-tilt) large-area collimated coating device Z, which includes a base module 1, a rotating module 2 and a carrier module D.

Referring to FIG. 1 to FIG. 5, the base module 1 can be configured to support the rotating module 2. The base module 1 may include a base assembly 10 and a barrier assembly 11. The base assembly 10 can be detachably fixed on the ground or the stage (or the substrate). The base assembly 10 has a positioning element 100, and the positioning element 100 has a recessed portion 100a. The barrier assembly 11 may be a hollow structure, the barrier assembly 11 is connected to the base assembly 10 and is located on the base assembly 10, and the barrier assembly 11 may be a single component, or may be multiple assembled components.

Next, referring to FIG. 1 to FIG. 5, the rotating module 2 can be movably disposed on the base module 1. For example, the rotating module 2 can be configured to drive the module body D1 to rotate around a second axis so that the module body D1 can be in a horizontal state, a tilted state or a vertical state. The second axis is different from the first axis of the second driving assembly D4. The rotating module 2 may include a power assembly 20 and a linkage assembly 21. The power assembly 20 can be movably connected to the base module 1. The power assembly 20 can be a motor or any type of driver. The power assembly 20 can be detachably connected to the base assembly 10. The linkage assembly 21 is connected to the power assembly 20 and partially disposed inside the base module 1.

Specifically, the linkage assembly 21 may include a transmission element 210, a fixing element 211 and a supporting element 212. The transmission element 210 can be movably connected to the power assembly 20, and the transmission element 210 can further include a transmission wheel 2100, a transmission belt 2101 and a movable part 2102. The transmission belt 2101 can be movably connected to the transmission wheel 2100 and the power assembly 20. The movable part 2102 may be a T-shaped and partially hollow structure. One end of the movable part 2102 can be detachably connected to the transmission element 210, and another end of the movable part 2102 can be movably and disposed inside the fixing element 211. A magnetic fluid (or ferrofuid) may be provided between the movable part 2102 and the fixing element 211, and the magnetic fluid can seal the gap between the movable part 2102 and the fixing element 211, and lubricate (smooth) the rotation of the movable part 2102. The fixing element 211 is a hollow structure, and the fixing element 211 is connected to the barrier assembly 11. The supporting element 212 is disposed inside the barrier assembly 11 and the fixed component 211, one end of the supporting element 212 can be detachably connected to the movable part 2102, and another end of the supporting element 212 is exposed outside the barrier assembly 11 and connected to the carrier module D. The supporting element 212 can be a long strip structure, and the supporting element 212 can be a single component, or may be multiple assembled components. When the supporting element 212 is a supporting assembly composed of the multiple assembled components, the operator can adjust the length of the supporting assembly (i.e., the supporting element 212) by adjusting the distance between the multiple assembled components. Furthermore, the power assembly 20 can be used to drive the linkage assembly 21 to rotate around a second axial direction (i.e., rotating in a first rotation direction or a second rotation direction), so that the carrier module D is in a tilted state. The first rotation direction can be clockwise or counterclockwise, the second rotation direction can be clockwise or counterclockwise, and the first rotation direction and the second rotation direction are opposite to each other. In addition, the transmission element 210 further includes a position-limiting piece 2103 detachably disposed on the transmission wheel 2100, and the position-limiting piece 2103 may be an arc-shaped structure. The position-limiting piece 2103 has a first position-limiting portion 2103a movably located in the recessed portion 100a.

Next, referring to FIG. 1, FIG. 2, and FIG. 4 to FIG. 7, the carrier module D may include a module body D1, a carrier assembly D2, at least one first driving assembly D3, and a second driving assembly D4. For example, the module body D1 may be connected to the rotating module 2, and the module body D1 may be a hollow box-shaped structure, but the present invention is not limited thereto. The module body D1 may have an accommodating space D10, a first opening D11 and a plurality of shielding elements D12. The accommodating space D10 may be communicated with the first opening D11. The plurality of shielding elements D12 may be movably disposed on the module body D1. The plurality of shielding elements D12 can be configured to open or shield the first opening D11. The shielding element D12 may be a thin plate structure. In addition, the module body D1 may further have a second opening D13 located on one side of the module body D1, and the first opening D11 is located on another side of the module body D1. The accommodating space D10 may be communicated with the first opening D11 and the second opening D13.

The carrier assembly D2 may be located in the accommodating space D10, and the carrier assembly D2 can be configured to hold or carry at least one object B. Furthermore, the carrier assembly D2 may include a position-limiting element D20 and a main body element D21. The position-limiting element D20 can be movably connected to the first driving assembly D3. The position-limiting element D20 may have a through hole D200, and the through hole D200 passes through the position-limiting element D20. The main body element D21 can be disposed inside the through hole D200 and can be movably disposed on the position-limiting element D20, one end of the main body element D21 can be movably connected to the second driving assembly D41 of the second driving assembly D4, and another end of the main body element D21 can be configured to hold the object B, in which one end of the main body element D21 may have a jagged (serrated) or snap-fitting structure, one end of the main body element D21 can be exposed from the second opening D13, and another end of the main body element D21 can be a clamping structure or any type of clamping element, but the present invention is not limited thereto.

The first driving assembly D3 can be movably connected to the carrier assembly D2, and the first driving assembly D3 can be configured to drive the carrier assembly D2 to reciprocate or perform a reciprocating displacement in a first direction F1 or a second direction F2. In the present embodiment, two first driving assemblies D3 are taken as an example. That is to say, the dual-tilt large-area collimated coating device Z may further include a plurality of first driving assemblies D3, and the plurality of first driving assemblies D3 are correspondingly arranged in the accommodating space D10 and can be movably connected to the carrier assembly D2, but the present invention is not limited thereto. In another optional embodiment, a single first driving assembly D3 and a guide rod element can be provided to cooperate with a position-limiting element D20. Furthermore, the first driving assembly D3 may include a connecting rod element D30 and a first driving element D31. The connecting rod element D30 can be movably disposed in the accommodating space D10 and connected to the module body D1. The connecting rod element D30 can be movably connected to one side of the carrier assembly D2. The connecting rod element D30 can be a screw rod or any other type of guiding component. The first driving element D31 is disposed in the accommodating space D10 and connected to the module body D1. The first driving element D31 can be movably connected to the connecting rod element D30. The first driving element D31 can be configured to drive the connecting rod element D30 to rotate so that the connecting rod element D30 can drive the carrier assembly D2 to move, and the first driving element D31 can be a motor or any other type of driver.

The second driving assembly D4 can be movably connected to the carrier assembly D2, and the second driving assembly D4 can be configured to drive the carrier assembly D2 to rotate around a first axial direction. Furthermore, the second driving assembly D4 may include an assembly body D40 and a second driving assembly D41. The assembly body D40 may be disposed on the module body D1, and the assembly body D40 may be a frame structure, but the present invention is not limited thereto. The second driving assembly D41 can be disposed on the assembly body D40 and can be movably connected to one end of the main body element D21 of the carrier assembly D2. The second driving assembly D41 can be configured to drive the carrier assembly D2 to rotate, and the second driving assembly D41 can be a motor or any other type of driver. In addition, the second driving assembly D4 may correspond to the second opening D13.

Therefore, referring to FIG. 1 to FIG. 9, when the dual-tilt large-area collimated coating device Z of the present invention is performing a coating process, the carrier module D and a portion of the supporting element 212 exposed outside the barrier assembly 11 can be located in an operating chamber 3 which is in a vacuum state, and an external coating source E (such as a crucible, but the present invention is not limited thereto) is provided in the operating chamber 3. The external coating source E is located under the carrier module D (that is to say, the first opening D11 of the carrier module D faces the external coating source E). Furthermore, the carrier assembly D2 of the carrier module D can hold an object B (a wafer is used as an example in this embodiment, but the present invention is not limited thereto).

Next, during the coating process for the object B, the external coating source E can provide a coating material (not shown in figures) toward the carrier module D, and the coating material can adhere to the surface of the object B through the first opening D11 of the module body D1, thereby forming a film layer (not shown in figures).

During the coating process, the dual-tilt large-area collimated coating device Z of the present invention can drive the transmission element 210 to rotate in the first rotation direction or the second rotation direction around the axis AC1 (i.e., the second axial direction) through the power assembly 20, so that the transmission element 210 can drive the movable part 2102 and the supporting element 212 to rotate together, and the supporting element 212 can drive the carrier module D to rotate at the same time, and make the carrier module D present a tilted state (as shown in FIG. 9). Next, when the external coating source E provides coating materials to the carrier module D, more coating materials may adhere to the surface of the object B closer to the first opening D11, and less coating materials may adhere to the surface of the object B farther from the first opening D11. Furthermore, the dual-tilt large-area collimated coating device Z can also drive the connecting rod element D30 to rotate by the first driving element D31, and drive the carrier assembly D2 to move in the first direction F1 or the second direction F2, so that the surface to be coated of the object B can be closer to or correspond to the first opening D11. Moreover, the dual-tilt large-area collimated coating device Z of the present invention can also drive the carrier assembly D2 to perform axial rotation (i.e., rotating in place) around the axis AC2 (i.e., the first axial direction) through the second driving assembly D41 of the second driving assembly D4, so that the surface to be coated of the object B can be close to or correspond to the first opening D11, in which the second driving assembly D41 can drive the carrier assembly D2 to rotate in a clockwise direction or a counterclockwise direction. In addition, the operator can also manually adjust the position of at least one shielding element D12 to adjust the size of the first opening D11.

Thus, when the coating process is being performed, the dual-tilt large-area collimated coating device Z of the present invention can separately or simultaneously drive the module body D1 of the carrier module D to perform multi-axial movement by cooperation of the rotating module 2, the first driving assembly D3 and the second driving assembly D4 to adjust the position or angle of the module body D1, and can also solve the problem of uneven film thickness by adjusting the size of the first opening D11 when the object B is tilted for coating, thereby allowing the coating film on the surface (or a specific area of the surface) of the object B to be more uniform. Furthermore, the dual-tilt large-area collimated coating device Z of the present invention can also form a coating film having a uniform thickness on the surface of a large-sized object B, and can also uniformly form a coat film on a specific area of the surface of the object B, thereby improving the convenience and uniformity of coating.

In addition, based on the above content, referring to FIG. 1, FIG. 2 and FIG. 4 to FIG. 9, the present invention may further provide a carrier module D, which can be applied to a dual-tilt large-area collimated coating device Z. The carrier module D may include a module body D1, a carrier assembly D2 (an object carrying assembly), at least one first driving assembly D3 and a second driving assembly D4. The module body D1 can be connected to the rotating module 2. The module body D1 may have an accommodating space D10, a first opening D11 and a plurality of shielding elements D12. The accommodating space D10 can be communicated with the first opening D11. The plurality of shielding elements D12 can be movably arranged on the module body D1. The plurality of shielding elements D12 can be configured to open or close (cover or shield) the first opening D11. The carrier assembly D2 may be located in the accommodating space D10, and the carrier assembly D2 can be configured to hold at least one object B. The at least one first driving assembly D3 can be movably connected to the carrier assembly D2. The at least one first driving assembly D3 can be configured to drive the carrier assembly D2 to perform a reciprocating displacement in a first direction or a second direction. The second driving assembly D4 can be movably connected to the carrier assembly D2, and the second driving assembly D4 can be configured to drive the carrier assembly D2 to rotate around a first axial direction.

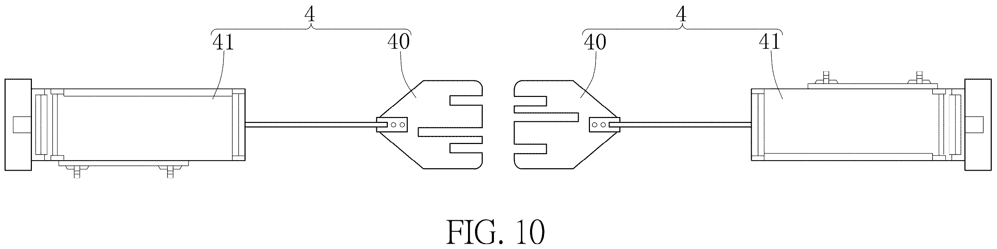

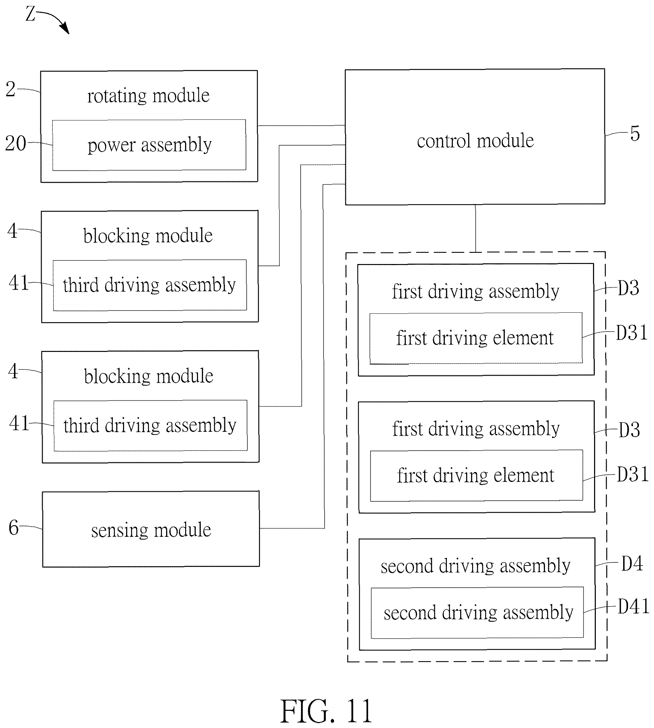

Referring to FIG. 1 to FIG. 9, FIG. 10 and FIG. 11, in which FIG. 10 is a schematic structural diagram of a blocking module according to a second embodiment of the present invention, and FIG. 11 is a functional block diagram of the dual-tilt large-area collimated coating device according to the second embodiment of the present invention. As shown in the above figures, the dual-tilt large-area collimated coating device Z of the first embodiment is substantially similar to the dual-tilt large-area collimated coating device Z of the second embodiment, so that the arrangement or operation of the same components or assembles will not be repeated herein. The difference between the second embodiment and the first embodiment is that in the second embodiment, the dual-tilt large-area collimated coating device Z of the present invention may further include an operating chamber 3 (or a working chamber) and a plurality of blocking modules 4. The operating chamber 3 may have a chamber 30 and a barrier element 31. The barrier element 31 can be configured to divide the chamber 30 into a first space 300 and a second space 301. The first space 300 can be configured to accommodate the carrier module D. The barrier element 31 may have a third opening 310. The multiple blocking modules 4 can be relatively and correspondingly arranged in the operating chamber 3, each blocking module 4 may include a shielding component 40 and a third driving assembly 41, each shielding component 40 can be located in the first space 300 and can be movably connected to the corresponding third driving assembly 41, and each third driving assembly 41 can be configured to drive the corresponding shielding component 40 to move, so that the multiple shielding components 40 can be configured to open or close (cover or shield) the third opening 310. The second space 301 can be configured to accommodate an external coating source E, and the third opening 310 corresponds to the external coating source E.

For example, as shown in FIG. 8 to FIG. 10, the operating chamber 3 may be a chamber in a vacuum state. The blocking element 31 may be a partition structure. Each shielding component 40 may be a claw-shaped plate structure, and the third driving assembly 41 may be a motor or any other type of driver, but the present invention is not limited thereto.

Therefore, the dual-tilt large-area collimated coating device Z of the present invention can not only drive the module body D1 of the carrier module D to move in multiple axes by cooperation of the rotating module 2, the first driving assembly D3 and the second driving assembly D4 to adjust the position or angle of the module body D1 and the size of the first opening D11, but also utilize the third driving assembly 41 to drive the plurality of shielding components 40 relatively arranged to approach, overlap or move away from each other, so as to adjust the size of the shielded area of the third opening 310, thereby further improving the accuracy of uniform coating of the object B.

Furthermore, referring to FIG. 1 to FIG. 11, the dual-tilt large-area collimated coating device Z of the present invention may also include a control module 5 and a sensing module 6. The control module 5 can be a circuit board or a control machine with processing functions, but the present invention is not limited thereto. The control module 5 can be connected to the power assembly 20 of the rotating module 2, the first driving element D31 and the second driving assembly D4 of the first driving assembly D3, and the third driving assembly 41 of the blocking module 4. The control module 5 can drive at least one of the power assembly 20, the first driving element D31, the second driving assembly D4 and the third driving assembly 41 to operate according to at least one control command (such as an instruction or a signal, but not limited thereto). The sensing module 6 can be a film thickness sensor. The sensing module 6 can be arranged on the inner wall of the barrier element 31 (or the partition element) and adjacent to the module body D1, or arranged on the outside of the module body D1 of the carrier module D and adjacent to the first opening D11, or arranged inside the module body D1 (i.e., in the accommodating space D10). The sensing module 6 can be connected to the control module 5, and the sensing module 6 can be configured to detect the thickness of the coating film on the object B and generate at least one film thickness signal of the coating film. The control module 5 can be configured to receive a film thickness signal and determine whether the thickness of the coating film coated on the object B is uniform according to the film thickness signal. Therefore, if the control module 5 determines that the film thickness coated on the object B is uneven (not uniform) according to the film thickness signal, the control module 5 can drive at least one of the power assembly 20, the first driving element D31, the second driving assembly D4 and the third driving assembly 41 to operate, so as to drive the thicker coating portion of the coating film on the object B away from the first opening D11 or the external coating source E and the thinner coating portion of the coating film on the object B to approach (or be adjacent) to the first opening D11 or the external coating source E.

However, the aforementioned details are disclosed for exemplary purposes only, and are not meant to limit the scope of the present invention.

### [Beneficial Effects of the Embodiments]

One of the beneficial effects of the present invention is that the dual-tilt large-area collimated coating device Z and the carrier module D provided by the present invention can make the film thickness coated on the object B more uniform during the tilt coating through the above-mentioned technical solution.

Furthermore, when the coating process is being performed, the dual-tilt large-area collimated coating device Z of the present invention can separately or simultaneously drive the module body D1 of the carrier module D to perform multi-axial movement by cooperation of the rotating module 2, the first driving assembly D3 and the second driving assembly D4 to adjust the position or angle of the module body D1, and can also solve the problem of uneven film thickness by adjusting the size of the first opening D11 when the object B is tilted for coating, thereby allowing the coating film on the surface (or a specific area of the surface) of the object B to be more uniform. Furthermore, the dual-tilt large-area collimated coating device Z of the present invention can also utilize the third driving assembly 41 to drive the shielding components 40 to move to be close to or far away from each other, so as to adjust the size of the shielded range (area) of the third opening 310 and further improve the accuracy of uniform coating of the object B.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A dual-tilt large-area collimated coating device (Z), **characterized by** comprising:
a base module (1);
a rotating module (2) movably disposed on the base module (1); and
a carrier module (D), comprising:
a module body (D1) connected to the rotating module (2), the module body (D1) having an accommodating space (D10), a first opening (D11) and a plurality of shielding elements (D12), the accommodating space (D10) being in communication with the first opening (D11), the plurality of shielding elements (D12) being movably disposed on the module body (D1), and the plurality of shielding elements (D12) being configured to open or close the first opening (D11);
a carrier assembly (D2) located in the accommodating space (D10), and the carrier assembly (D2) being configured to hold at least one object (B);
at least one first driving assembly (D3) movably connected to the carrier assembly (D2), and the at least one first driving assembly (D3) being configured to drive the carrier assembly (D2) to reciprocate in a first direction (F1) or a second direction (F2); and
a second driving assembly (D4) movably connected to the carrier assembly (D2), and the second driving assembly (D4) being configured to drive the carrier assembly (D2) to rotate around a first axis (AC2).

2. The dual-tilt large-area collimated coating device (Z) according to claim 1, wherein, when the rotating module (2) is configured to drive the module body (D1) to rotate around a second axis (AC1) that is different from the first axis, the module body (D1) is in a horizontal state, a tilted state or a vertical state.

3. The dual-tilt large-area collimated coating device (Z) according to claim 1, wherein the first driving assembly (D3) comprises:
a connecting rod element (D30) movably disposed in the accommodating space (D10) and connected to the module body (D1), wherein the connecting rod element (D30) is movably connected to the carrier assembly (D2); and
a first driving element (D31) disposed in the accommodating space (D10) and connected to the module body (D1), wherein the first driving element (D31) is movably connected to the connecting rod element (D30);
wherein, when the first driving element (D31) is configured to drive the connecting rod element (D30) to rotate, the connecting rod element (D30) drives the carrier assembly (D2) to move.

4. The dual-tilt large-area collimated coating device (Z) according to claim 1, further comprises a plurality of the first driving assemblies (D3), the plurality of the first driving assemblies (D3) being correspondingly disposed in the accommodating space (D10) and movably connected to the carrier assembly (D2); wherein the second driving assembly (D4) comprises:
an assembly body (D40) disposed on the module body (D1); and
a second driving element (D41) disposed on the assembly body (D40) and movably connected to the carrier assembly (D2), wherein the second driving element (D41) is configured to drive the carrier assembly (D2) to rotate.

5. The dual-tilt large-area collimated coating device (Z) according to claim 1, wherein the carrier assembly (D2) comprises:
a position-limiting element (D20) movably connected to the first driving assembly (D3), wherein the position-limiting element (D20) has a through hole (D200); and
a main body element (D21) disposed inside the through hole (D200) and movably disposed on the position-limiting element (D20), wherein one end of the main body element (D21) is movably connected to the at least one first driving assembly (D3), and another end of the main body element (D21) is configured to hold the at least one object (B).

6. The dual-tilt large-area collimated coating device (Z) according to claim 1, further comprising:
an operating chamber (3) comprising a chamber (30) and a barrier element (31), wherein the barrier element (31) is configured to divide the chamber (30) into a first space (300) and a second space (301), the first space (300) is configured to accommodate the carrier module (D), and the barrier element (31) has a third opening (310); and
a plurality of blocking modules (4) correspondingly disposed in the operating chamber (3), wherein each of the plurality of blocking modules (4) includes a shielding component (40) and a third driving assembly (41), the shielding component (40) is located in the first space (300) and movably connected to the third driving assembly (41), and the third driving assembly (41) is configured to drive the shielding component (40) to move to open or close the third opening (310);
wherein the second space (301) is configured to accommodate an external coating source (E), and the third opening (310) corresponds to the external coating source (E).

7. A carrier module (D) applied to a dual-tilt large-area collimated coating device (Z), **characterized by** comprising:
a module body (D1) connected to the dual-tilt large-area collimated coating device (Z), the module body (D1) having an accommodating space (D10), a first opening (D11) and a plurality of shielding elements (D12), the accommodating space (D10) being in communication with the first opening (D11), the plurality of shielding elements (D12) being movably disposed on the module body (D1), and the plurality of shielding elements (D12) being configured to open or close the first opening (D11);
a carrier assembly (D2) located in the accommodating space (D10), and the carrier assembly (D2) being configured to hold at least one object (B);
at least one first driving assembly (D3) movably connected to the carrier assembly (D2), and the at least one first driving assembly (D3) being configured to drive the carrier assembly (D2) to reciprocate in a first direction (F1); and
a second driving assembly (D4) movably connected to the carrier assembly (D2), and the second driving assembly (D4) being configured to drive the carrier assembly (D2) to rotate around a first axis (AC2).

8. The carrier module (D) according to claim 7, wherein the first driving assembly (D3) comprises:
a connecting rod element (D30) movably disposed in the accommodating space (D10) and connected to the module body (D1), wherein the connecting rod element (D30) is movably connected to the carrier assembly (D2); and
a first driving element (D31) disposed in the accommodating space (D10) and connected to the module body (D1), wherein the first driving element (D31) is movably connected to the connecting rod element (D30);
wherein, when the first driving element (D31) is configured to drive the connecting rod element (D30) to rotate, the connecting rod element (D30) drives the carrier assembly (D2) to move.

9. The carrier module (D) according to claim 7, further comprises a plurality of the first driving assemblies (D3), the plurality of the first driving assemblies (D3) being correspondingly disposed in the accommodating space (D10) and movably connected to the carrier assembly (D2); wherein the second driving assembly (D4) comprises:
an assembly body (D40) disposed on the module body (D1); and
a second driving element (D41) disposed on the assembly body (D40) and movably connected to the carrier assembly (D2), wherein the second driving element (D41) is configured to drive the carrier assembly (D2) to rotate.

10. The carrier module (D) according to claim 7, wherein the carrier assembly (D2) comprises:
a position-limiting element (D20) movably connected to the first driving assembly (D3), wherein the position-limiting element (D20) has a through hole (D200); and
a main body element (D21) disposed inside the through hole (D200) and movably disposed on the position-limiting element (D20), wherein one end of the main body element (D21) is movably connected to the at least one first driving assembly (D3), and another end of the main body element (D21) is configured to hold the at least one object (B).
